# EUROPEAN PATENT APPLICATION

(11) **EP 4 636 409 A1**
(43) Date of publication of application: **22.10.2025**
(21) Application number: 23901769.2
(22) Date of filing: 02.10.2023
(51) Int. Cl.: G01R 15/20

(54) **CURRENT SENSOR**

(30) Priority: 12.12.2022 JP 2022197903
(71) Applicant: Alps Alpine Co., Ltd., Tokyo 145-8501 (JP)
(72) Inventor: TAMURA, Manabu, Tokyo 145-8501 (JP); TAKANO, Hideaki, Tokyo 145-8501 (JP); UEDA, Chiaki, Tokyo 145-8501 (JP); KUMAGAI, Yuu, Tokyo 145-8501 (JP)
(74) Representative: Maiwald GmbH
(86) International application number: PCT/JP2023/035826
(87) International publication number: WO 2024/127770

(57) **Abstract**

A current sensor 1 includes a core member 2 having a first gap 22 between end surfaces 21 and having a circular shape through which a busbar 4 is insertable, the core member 2 being configured to concentrate a magnetic field generated when a current to be measured passes through the busbar 4, and a magnetic detector 3 configured to detect the magnetic field concentrated by the core member 2. The magnetic detector 3 has a detection surface 31 that detects the magnetic field and detects the magnetic-field components parallel to the detection surface 31, and the detection surface 31 is disposed parallel to the direction in which the two end surfaces 21 defining the first gap 22 face each other. Accordingly, the current sensor 1 is suitable for miniaturization and reduced thickness.

## Description

### Technical Field

The present invention relates to a current sensor that detects a magnetic field generated by a current to be measured that is flowing through a conductor, and measures a current value of the current to be measured based on the detected magnetic field.

### Background Art

In recent years, current sensors have been used to measure a current to be measured flowing through in various devices by attaching the sensors to the various devices to control or monitor the devices. Such a known current sensor includes a magnetoelectric conversion element that detects a magnetic field generated by the current to be measured that is flowing through a current path. Another known current sensor includes a core member that surrounds a current path to ease the detection of the magnetic field, and includes a Hall element as a magnetoelectric conversion element that is provided in a gap of the core member.

Patent Literature 1 describes a current detector that includes a magnetic core and a Hall element to prevent current detection errors caused by pressure applied to the magnetic core or other factors. Patent Literature 2 describes a current detector configured to achieve both downsizing of the magnetic core and suppression of decreases in detection accuracy caused by noise magnetic lines. The current detector includes a magnetic core that is formed continuously to surround a hollow part and has both ends facing each other with a gap therebetween, and a Hall element that is disposed in the gap and detects the magnetic flux that changes in response to the current passing through the hollow part.

### Citation List

### Patent Literature

PTL 1: Japanese Unexamined Patent Application Publication No. 2013-142579
PTL 2: Japanese Unexamined Patent Application Publication No. 2012-247197

### Summary of Invention

### Technical Problem

The current detectors described in patent Literatures 1 and 2 have variations in detection accuracy when the positions of the Hall elements are instable within the gap of the core member. To solve the problem, a structure and components are required to stably maintain the positions of the Hall elements when the current detectors vibrate. In addition, such a Hall element detects a magnetic field in a direction perpendicular to the detection surface, and thus the detection surface of the Hall element and the end surfaces of the core member in the gap need to be disposed to face each other. Accordingly, the end surfaces that define the gap need to have an area approximately the same as the detection surface of the Hall element. For these reasons, it has been difficult to downsize and reduce the thickness of the current detectors. The present invention has been made to provide a current sensor that is capable of stably maintaining the position of a magnetoelectric conversion element even when vibration occurs and is suitable for downsizing and reducing the thickness.

### Solution to Problem

A device according to an aspect of the invention for solving the above-described problems includes the following structures. A current sensor includes a core member having a first gap between end surfaces and having a circular shape through which a busbar is insertable, the core member being configured to concentrate a magnetic field generated when a current to be measured passes through the busbar, and a magnetic detector configured to detect the magnetic field concentrated by the core member. The magnetic detector has a detection surface that detects the magnetic field and detects the magnetic-field components parallel to the detection surface, and the detection surface is disposed parallel to the direction in which the two end surfaces defining the first gap face each other. This structure eliminates the necessity to match the size of the end surfaces of the first gap to the size of the detection surface of the magnetic sensor, thereby reducing the height of the core member.

The magnetic detector may be provided on a substrate by surface mounting, and the plate surface of the substrate may be orthogonal to the end surfaces of the core member. With this structure, even if the current sensor is subjected to vibration, the position of the magnetic detector is not readily displaced in the direction parallel to the surface of the substrate, and even when the substrate is bent, the detection surface is not tilted with respect to the detection surface. Accordingly, a decrease in detection accuracy due to vibration can be prevented without providing structures or components for stably maintaining the position of the detection surface.

The substrate and the core member may be secured to each other. This structure stabilizes the positional relationship between the magnetic detector and the core member, thereby reducing detection errors due to mounting position errors.

The core member may have a second gap at a position different from the first gap. With the second gap, the magnitude of magnetic fields to be detected by the magnetic detector can be adjusted. Accordingly, it is possible to vary the measurable range of the current sensor by using the same magnetic detector and the substrate.

The current sensor may include a housing accommodating the magnetic detector and the core member. The housing may have a busbar through hole into which the busbar is insertable. The busbar through hole may be provided to pass through inside a circular space defined by the core member, and in a cross-section of the busbar through hole, a first clearance width in the direction in which the two end surfaces defining the first gap face each other may be larger than a second clearance width in the direction orthogonal to the direction in which the two end surfaces face each other. The first and second clearance widths facilitate insertion of the busbar into the busbar through hole. In addition, with the first clearance width larger than the second clearance width, even if the busbar is mounted at a position shifted from the center of the busbar through hole, the current sensor with small measurement deviation can be provided.

The current sensor may include the busbar configured to carry the current to be measured in which the busbar may be disposed to pass through inside a circular space defined by the core member, and may include a housing integrally holding the magnetic detector, the core member, and the busbar. Such an integrally formed busbar and housing prevents misalignments between the busbar and the housing, thereby providing the current sensor with good detection accuracy.

When viewed in an axial direction of a central axis of the circular portion of the core member, the magnetic detector may be disposed at a position shifted with respect to a straight line passing through centers of the two end surfaces defining the first gap, and at least part of the magnetic detector may be disposed to overlap the first gap. This structure reduces detection magnetic fields generated by currents to be measured, and thus increases the ranges of currents that can be measured by the current sensor.

A detection element of the magnetic detector may be a magnetoresistance effect element. The use of a magnetoresistance effect element enables the detection surface to be disposed parallel to the direction in which the two end surfaces defining the first gap face each other, and thus the structure is advantageous for miniaturization of the current sensor.

The magnetic detector may be disposed outside the first gap, and when viewed in a direction orthogonal to the detection surface, may be disposed to overlap the first gap. This structure reduces the effect of heat due to Joule heat from the busbar on the magnetic detector when the current to be measured flows, thereby increasing the detection accuracy and durability of the current sensor.

At the detection surface, when viewed in a direction orthogonal to the direction in which the end surfaces defining the first gap face each other, the magnetic detector may be disposed, with respect to the first gap, in an axial direction of a central axis of the circular portion of the core member, and when viewed in the axial direction of the central axis of the circular portion of the core member, the magnetic detector may be disposed to overlap the first gap. With this structure, when the current sensor has a plurality of measurement phases, a magnetic field from an adjacent measurement phase contains many components that are orthogonal to the sensitivity direction of the detector, and thus the effect from the adjacent measurement phase can be reduced. Accordingly, the detection accuracy of the current sensor can be increased.

A grounded substrate may be disposed between the core member and the magnetic detector. With this structure, when the core member receives electromagnetic noise, the electromagnetic noise can be shielded by the GND of the substrate, thereby increasing the noise resistance of the current sensor.

A sub-magnetic detector may be disposed on a side of the substrate opposite to the side on which the magnetic detector is disposed. A detection element of the sub-magnetic detector may be a magnetoresistance effect element and may be disposed outside the first gap of the core member. By providing a sub-magnetic detector in addition to the magnetic detector, the redundancy can be increased and the highly reliable current sensor can be provided.

A detection element of the magnetic detector may be a magnetoresistance effect element, a detection element of the sub-magnetic detector may be a Hall sensor, and the Hall sensor may be disposed in the first gap of the core member. By providing the magnetic detector and the sub-magnetic detector as different detection elements, the simultaneous occurrence of a problem in each detection element can be reduced. Accordingly, the detection reliability of the current sensor can be increased.

### Advantageous Effects of Invention

According to the present invention, it is not necessary to configure the core member to have end surfaces of approximately the same area as the detection surface of the magnetic detector, and the thickness of the core member can be adjusted depending on the magnitude of the current to be measured. Accordingly, the current sensor suitable for miniaturization and reduced thickness can be provided. Brief Description of Drawings
[Fig. 1A] Fig. 1A is a front view of a current sensor according to a first embodiment.
[Fig. 1B] Fig. 1B is a side view of the current sensor according to the first embodiment.
[Fig. 2] Fig. 2 is a perspective diagram of a core of a current sensor according to a modification.
[Fig. 3] Fig. 3 is a front view of a current sensor according to another modification.
[Fig. 4] Fig. 4 is an exploded perspective view of a current sensor.
[Fig. 5A] Fig. 5A is a front view of a current sensor according to another modification.
[Fig. 5B] Fig. 5B is a magnified cross-sectional view of a busbar and a busbar through hole in the current sensor in Fig. 5A.
[Fig. 6] Fig. 6 is a graph illustrating effects of displacement of the busbar on the sensitivity in the current sensor according to the modification in Fig. 5A.
[Fig. 7A] Fig. 7A is a front view of a current sensor according to another modification.
[Fig. 7B] Fig. 7B is a magnified cross-sectional view of a busbar and a busbar through hole in the current sensor in Fig. 7A.
[Fig. 8] Fig. 8 is a front view of a current sensor according to another modification.
[Fig. 9] Fig. 9 is a front view of core members and first gaps when busbars are energized, in which the temperature of the core members and the first gaps is shown in shades of gray.
[Fig. 10A] Fig. 10A is a front view of a current sensor according to a second embodiment.
[Fig. 10B] Fig. 10B is a side view of the current sensor according to the second embodiment.
[Fig. 11] Fig. 11 is a side view and a graph illustrating a relationship between the position of a magnetic detector in a current sensor and magnetic flux density.
[Fig. 12] Fig. 12 is a vector diagram illustrating the results of a simulation of magnetic fields generated in a conducting phase and an adjacent phase by the current flowing through a busbar in the conducting phase.
[Fig. 13A] Fig. 13A is a front view of a current sensor according to a modification.
[Fig. 13B] Fig. 13B is a side view of a current sensor according to a modification.
[Fig. 14] Fig. 14 is a side view of a current sensor according to another modification.
[Fig. 15] Fig. 15 is a side view of a current sensor according to another modification.
[Fig. 16A] Fig. 16A is a front view of a known current sensor.
[Fig. 16B] Fig. 16B is a side view of a known current sensor.

### Description of Embodiments

Hereinafter, embodiments of the present invention will be described with reference to the attached drawings. In each drawing, the same numerals are given to the same components, and their descriptions are omitted. Reference coordinates are shown in each drawing as appropriate to indicate the positional relationship of each component. In the reference coordinates, "X direction" denotes a direction in which end surfaces of a core member that define a first gap face each other, "Y direction" denotes a direction orthogonal to the X direction on a detection surface of the magnetic detector, and "Z direction" denotes an axial direction of a central axis of a circular portion of the core member.

### [First Embodiment]

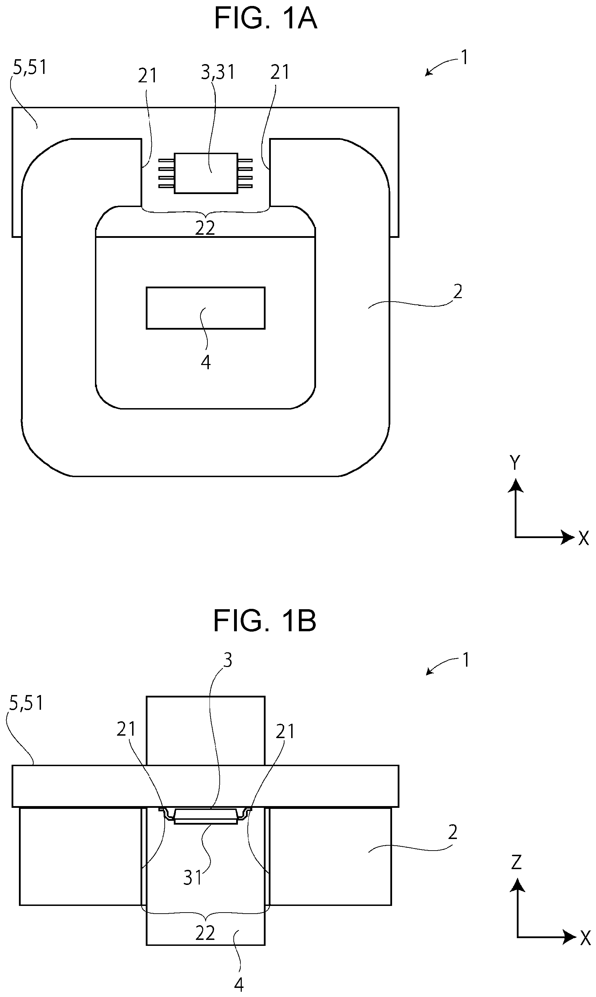

Fig. 1A and Fig. 1B are a front view and a side view of a current sensor 1 according to the embodiment respectively. The current sensor 1 includes a core member 2 and a magnetic detector 3. The core member 2 is a member that comprises magnetic material, has a first gap 22 that is formed between end surfaces 21, and has a circular shape through which a busbar 4 can be inserted. When a current to be measured flows through the busbar 4, a magnetic field generated from the busbar 4 is concentrated in the first gap 22, and the magnetic field in the first gap 22 is detected by the magnetic detector 3. It should be noted that in the following embodiments, the embodiments in which the busbar 4 is inserted through the core member 2 will be described; however, the present invention may be implemented as an embodiment in which a conductor other than the busbar 4 is inserted through the core member 2. In such a case, the current sensor 1 measures a current to be measured that is flowing through the conductor. The core member 2 may comprise a plurality of circular plates stacked in the Z direction, in which the Z direction is a plate thickness direction.

The magnetic detector 3 detects a magnetic field, which is generated when a current to be measured flows through the busbar 4, in the first gap 22. The magnetic detector 3 is separated from the busbar 4 in the Y direction and is disposed such that a detection surface 31 is orthogonal to a plate surface of the busbar 4. The busbar 4 is a conductive material comprising copper, brass, aluminum, or a similar material, and through which a current to be measured, which is a detection target, flows. The busbar 4 is formed in a plate shape and is disposed to pass through the core member 2, which has a circular shape. It should be noted that in this embodiment, the busbar 4 is formed in the plate shape; however, its shape is not limited to the plate shape. For example, a cross-sectional shape of the busbar 4 parallel to the X-Y plane may be circular.

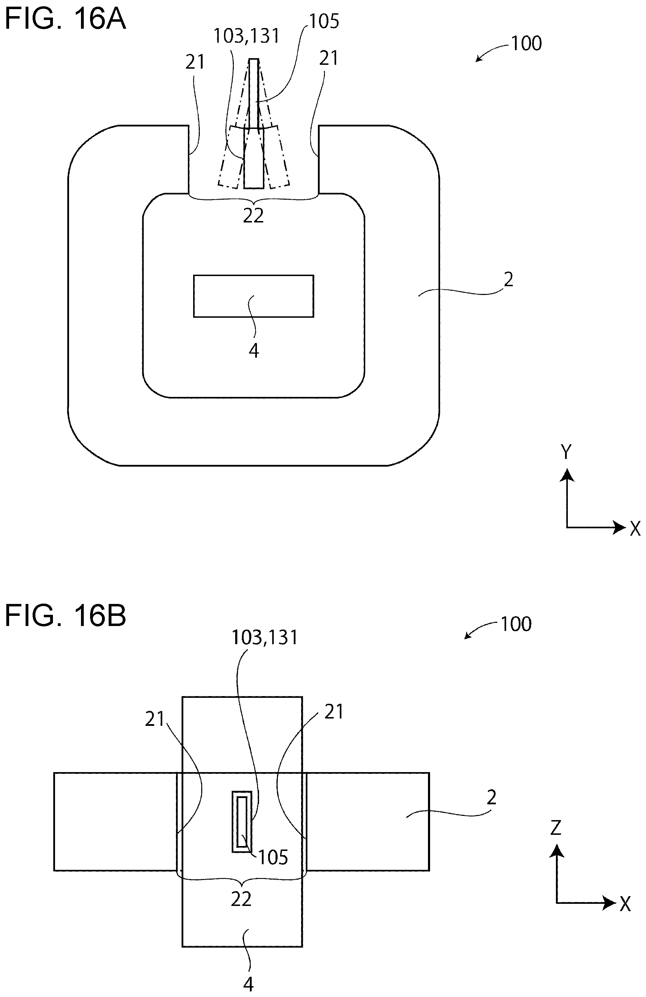

Fig. 16A and Fig. 16B are a plan view and a front view of a known current sensor 100 respectively. The current sensor 100 includes a Hall element 103 as a magnetic detector for detecting a magnetic field in the first gap 22. A detection surface 131 of the Hall element 103 and end surfaces 21 of a core member 2 in the first gap 22 face each other. The area of the end surface 21 in the first gap 22 needs to be approximately the same as the area of the detection surface 131 of the Hall element 103, and thus it is difficult to provide a smaller and thinner current sensor 100.

In contrast, as illustrated in Fig. 1A and Fig. 1B, the detection surface 31 of the magnetic detector 3 in the current sensor 1 according to the embodiment can detect magnetic field components parallel to the detection surface 31. In addition, the detection surface 31 is disposed parallel to the direction in which the two end surfaces 21 defining the first gap 22 face each other such that the sensitivity direction is the X direction and is parallel to the XY plane.

This structure eliminates the necessity to match the size of the end surface 21 of the core member 2 defining the first gap 22 to the size of the detection surface 31 of the magnetic detector 3 in the current sensor 1. Accordingly, when the current that flows through the busbar 4 is small, the height of the core member 2 in the Z direction can be reduced, whereas, when the current that flows through the busbar 4 is large, the width in the X direction can be increased without increasing the height of the core member 2.

The magnetic detector 3 is provided on a substrate 5 that comprises epoxy glass, ceramic, or the like by surface mounting. A plate surface 51 of the substrate 5 that is parallel to the XY plane is orthogonal to the end surfaces 21 of the core member 2 that are parallel to the XZ plane.

By providing the magnetic detector 3 on the substrate 5 by surface mounting, that is, by providing the magnetic detector 3 such that the detection surface 31 is parallel to the plate surface 51 of the substrate 5, the current sensor resistant to vibration can be provided. When the magnetic detector 3 is provided with a magnetoresistance effect element or the like such as a giant magnetoresistance effect (GMR) element, a tunneling magnetoresistance effect (TMR) element, or the like, as a detection element, such an element can be provided on the substrate 5 by surface mounting.

In the known current sensor 100 illustrated in Fig. 16A, the Hall element 103 as the magnetic detector is attached to a holding member 105 that is elongated in the Y direction. Accordingly, when the current sensor 100 is subjected to vibration, the position of the Hall element 103 may change as indicated by alternating long and short dashed lines in the drawing. Changes in the position of the Hall element 103 cause the detection surface 131 to be tilted with respect to the detection magnetic field in the direction (X direction) facing the end surfaces 21, and in such a case, the detection accuracy of the current sensor 100 is decreased.

In contrast, in the current sensor 1 according to the embodiment, the magnetic detector 3 is mounted on the substrate 5 by surface mounting. Accordingly, the tilt of the detection surface 31 with respect to the detection magnetic field can be prevented without providing a member or structure for holding the magnetic detector 3. In addition, even if the current sensor 1 is subjected to vibration, the position of the magnetic detector 3 is not readily displaced in the direction parallel to the plate surface 51 of the substrate 5. Furthermore, even when the substrate 5 is momentarily bent in the Z direction, the detection surface 31 is not tilted with respect to the detection magnetic field. In other words, when the current sensor 1 is not subjected to vibration, the direction of the magnetic field generated in the first gap 22 is the X direction, and in this state, the direction in which the magnetic detector 3 can detect the magnetic components is also the X direction. When the current sensor 1 is subjected to vibration and the substrate 5 is bent in the Z direction, the position of the detection surface 31 of the magnetic detector 3 is displaced along the side surface of the cylinder with a virtual axis parallel in the X direction as a center, while the sensitivity axis is maintained in the X direction. With this structure, the detection surface 31 can be in a state similar to a state in which the substrate 5 is rotated about the virtual axis parallel in the X direction from the position before the substrate 5 is bent in the Z direction. In other words, the magnetic components that can be detected by the magnetic detector 3 are still magnetic components in the X direction. Accordingly, the decrease in detection accuracy of the current sensor 1 caused by vibration can be reduced.

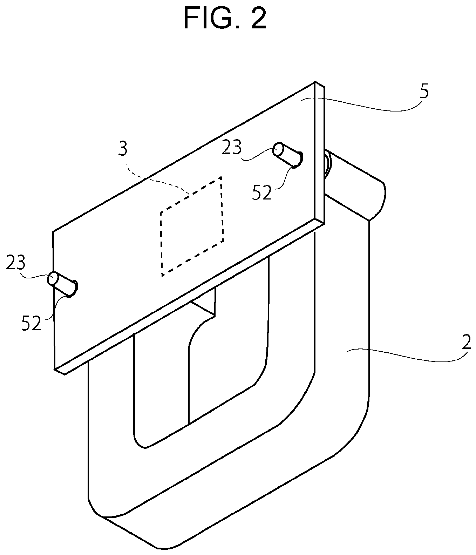

Fig. 2 is a perspective view of the core member 2 of the current sensor 1 according to a modification. The core member 2 is secured to the substrate 5 and thereby the positional relationship between the magnetic detector 3 disposed on the substrate 5 and the core member 2 is stabilized. This structure prevents the current sensor 1 from causing differences in detection accuracy due to differences in relative positions of the magnetic detector 3 and the core member 2.

In Fig. 2, convex portions 23 of the core member 2 are inserted into holes 52 of the substrate 5 to secure and integrate the core member 2 with the substrate 5. It should be noted that the method of integrating the core member 2 with the substrate 5 is not limited to this example. For example, the methods include a method of bonding the core member 2 and the substrate 5, a method of laminating the core member 2 and the substrate 5 by heating and applying pressure in a vacuum state, a method of plating the core member 2 and soldering the core member 2 to the substrate 5, and a method of crimping a pin to the core member 2 and soldering the pin to the substrate 5.

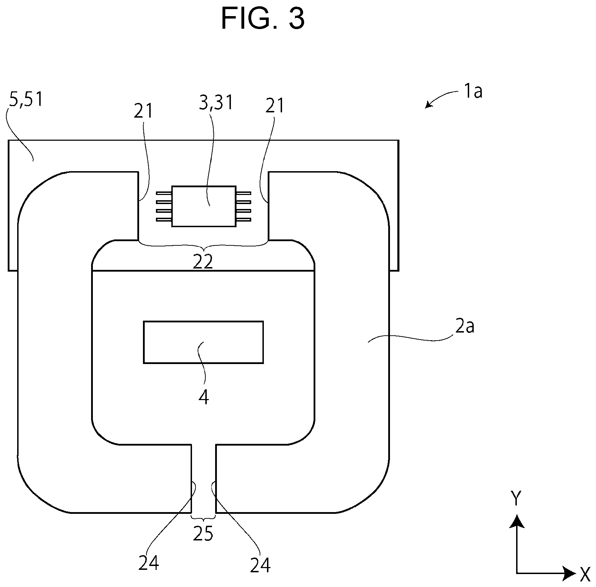

Fig. 3 is a plan view of a current sensor 1a according to another modification. The current sensor 1a illustrated in Fig. 3 is different from the current sensor 1 in that the current sensor 1a includes a core member 2a that has a second gap 25 that is different from the first gap 22. It should be noted that, when viewed in the Y direction, the positional relationship among the core member 2a, the magnetic detector 3, the detection surface 31, the busbar 4, and the substrate 5 is similar to that in the current sensor 1 illustrated in Fig. 1B.

With this structure in which the core member 2a is divided, it is possible to measure a larger current to be measured by using the same magnetic detector 3 and the substrate 5 as in measuring a smaller current to be measured. When the divided core member 2a is used, it is preferable that the core member 2a be integrated with the substrate 5 (see Fig. 2) to stabilize the positional relationship between the core member 2a and the magnetic detector 3.

The second gap 25 and the first gap 22 are defined on the opposite sides in the core member 2a in the Y direction. The distance between end surfaces 24, which face each other and define the second gap 25, is shorter than the distance between the end surfaces 21, which define the first gap 22. The distance between the end surfaces 24 and the distance between the end surfaces 21 may be set depending on the magnitude of currents to be measured respectively. For example, the distance between the end surfaces 24 may be set to approximately 0.5 to 3 mm, and the distance between the end surfaces 21 may be set to approximately 3 to 10 mm.

### [Measurement Examples]

Measurements were performed by using the current sensor 1 illustrated in Fig. 1 and the current sensor 1a illustrated in Fig. 3, by passing currents to be measured having different magnitudes through the busbars 4. The magnetic flux density detected by the magnetic detectors 3 is shown in Table 1. The distance between the end surfaces 21 in the first gap 22 in each of the current sensor 1 and the current sensor 1a was set to 9 mm, and the distance between the end surfaces 24 in the second gap 25 in the current sensor 1a was set to 1 mm.

**[Table 1]**

| Table 1 | Current To Be Measured | Detected Magnetic Flux Density |
|---|---|---|
| Current Sensor 1 (Fig. 1A) | 600 A | 61.6 mT |
| Current sensor 1a (Fig. 3) | 900 A | 64.1 mT |

As illustrated in Fig. 1, by using the divided core member 2a, the magnetic flux density of the magnetic field detected by the magnetic detector 3 can be adjusted. Accordingly, it is possible to adjust the measurement range of the current sensor.

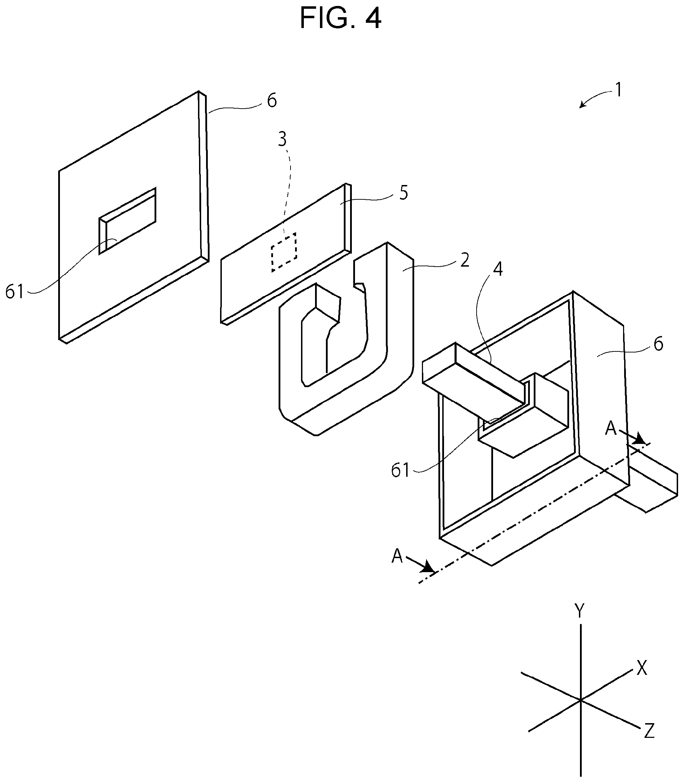

Fig. 4 is an exploded perspective view of the current sensor 1. As illustrated in Fig. 4, the current sensor 1 includes a housing 6 that accommodates the core member 2, the magnetic detector 3, and the substrate 5. The housing 6 has a busbar through hole 61 into which the busbar 4 is insertable. The current sensor 1 measures a current to be measured flowing through the busbar 4 by using the magnetic detector 3 in a state in which the busbar 4 is inserted into the busbar through hole 61, which passes through inside a circular space defined by the core member 2.

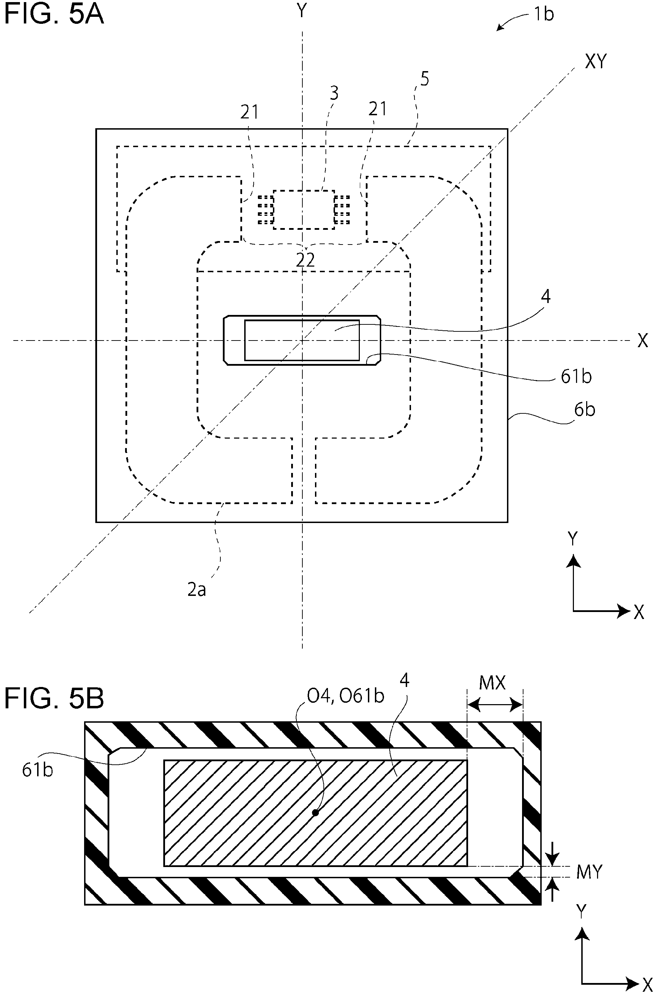

Fig. 5A is a front view of a current sensor 1b according to another modification. Fig. 5B is a magnified cross-sectional view of the busbar 4 and a busbar through hole 61b in the current sensor 1b in Fig. 5A, illustrating a portion taken along line A-A in Fig. 4 in an assembled state. As illustrated in the drawings, the cross-section of the XY plane of the busbar through hole 61b is a rectangle that is elongated in the X direction in which the two end surfaces 21 defining the first gap 22 face each other. This structure prevents the busbar 4 inserted into the busbar through hole 61b from being displaced and affecting the measurement sensitivity of the current sensor 1b.

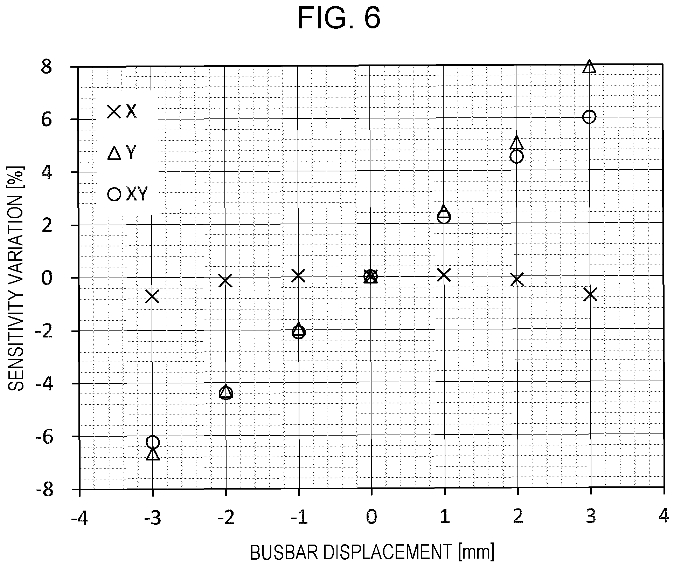

Fig. 6 is a graph illustrating effects of displacement of the busbar 4 on the sensitivity in the current sensor 1b according to the modification in Fig. 5A. Fig. 6 illustrates the sensitivity variation of the current sensor 1b when the busbar 4 is displaced in the X direction, the Y direction, or the XY direction from a predetermined position at which a center O4 of the busbar 4 and a center O61b of the busbar through hole 61b are aligned.

As illustrated in the graph in Fig. 6, when the busbar 4 is displaced in the X direction, the effect of the displacement on the sensitivity of the current sensor 1b is small. In contrast, when the busbar 4 is displaced in the Y direction or XY direction (see Fig. 5A), the effect of the displacement on the sensitivity of the current sensor 1b is large.

Accordingly, as illustrated in Fig. 5A and Fig. 5B, the cross-sectional shape of the busbar through hole 61b in a housing 6b has a first clearance width MX in the X direction that is larger than a second clearance width MY in the Y direction. In other words, in a state in which the busbar 4 is inserted into the busbar through hole 61b at a predetermined position, the first clearance width MX in the X direction, in which the end surfaces 21 defining the first gap 22 face each other, is larger than the second clearance width MY in the Y direction, which is perpendicular to the direction in which the end surfaces 21 face each other.

The first clearance width MX and the second clearance width MY provided in the busbar through hole 61b enable the busbar 4 to be readily inserted into the busbar through hole 61b. In addition, even if the busbar 4 is displaced from the predetermined position in the busbar through hole 61b, the direction of the displacement is in the X direction, which has a small effect on the sensitivity of the current sensor 1b. Accordingly, even if the busbar 4 is displaced from the predetermined position, the current sensor 1b can have a predetermined sensitivity.

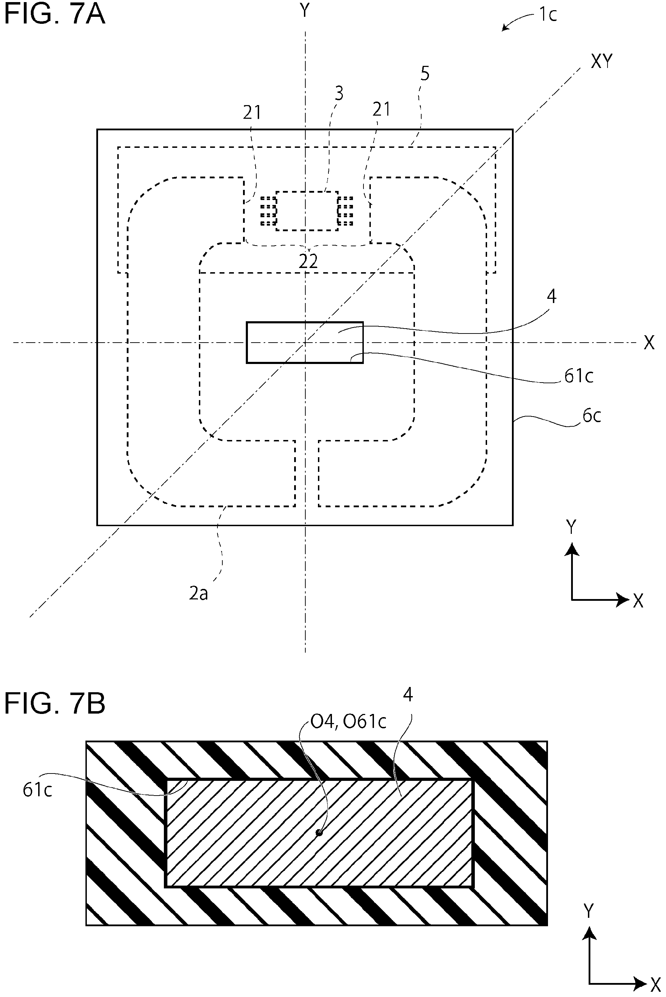

Fig. 7A is a front view of a current sensor 1c according to yet another modification. Fig. 7B is a magnified cross-sectional view of the busbar 4 and a busbar through hole 61c in the current sensor 1c in Fig. 7A, illustrating a portion taken along line A-A in Fig. 4 in an assembled state. The current sensor 1c is different from the current sensor 1b in that the busbar 4 is integrally held in a housing 6c that integrally holds the core member 2a, the magnetic detector 3, and the substrate 5. For example, by integrally forming part of the busbar 4 with the housing 6c by insert molding, the busbar 4 can be integrally held in the housing 6c. It should be noted that the structure in which the busbar 4 is disposed to pass through inside the circular space defined by the core member 2a is the same as that of the current sensor 1c and the current sensor 1b. The structure in which the busbar 4 is integrally held by the housing 6c prevents a misalignment between the center O61c of the busbar through hole 61c and the center O4 of the busbar 4, suppressing the occurrence of sensitivity variation caused by the displacement of the busbar 4, such as in the case illustrated in Fig. 6.

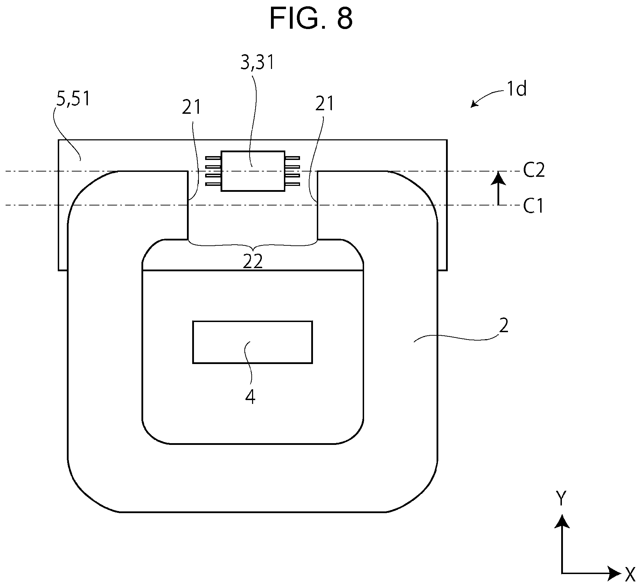

Fig. 8 is a front view of a current sensor 1d according to another modification. The current sensor 1d is different from the current sensor 1 in Fig. 1A in that the magnetic detector 3 is disposed at a position shifted with respect to the first gap 22 when viewed in the Z direction, which is the axial direction of the central axis of the circular portion of the core member 2 and is the direction in which the busbar 4 extends. More specifically, the magnetic detector 3 in the current sensor 1d is disposed at a position at which a center line C2 in the X direction that passes through centers of the width of the magnetic detector 3 in the Y direction is shifted from a center line C1 in the X direction that passes through centers of the width of the two end surfaces 21 defining the first gap 22 in the Y direction.

With this structure in which the magnetic detector 3 is shifted from the center of the first gap 22, it is possible to measure a larger current to be measured by using the core member 2, the magnetic detector 3, and the substrate 5 as in the case in which a small current to be measured is measured. The distance between the center line C1 and the center line C2 in the Y direction is set depending on the magnitude of a current to be measured, for example, may be set to approximately 1 to 10 mm.

The magnetic detector 3 is disposed such that at least part of the magnetic detector 3 overlaps the first gap 22 when viewed in the Z direction, and thus a magnetic field generated in the first gap 22 defined by the two end surfaces 21 can be accurately measured.

### [Measurement Examples]

Measurements were performed by using the current sensor 1 illustrated in Fig. 1A and the current sensor 1d illustrated in Fig. 8, by passing currents to be measured that have different magnitudes through the busbar 4. The magnetic flux density of the magnetic fields detected by the magnetic detector 3 in the measurement is shown in the following table. The distance between the end surfaces 21 of the first gap 22 in each of the current sensor 1 and the current sensor 1d was set to 9 mm, and the end surfaces 21 ware each 15 mm square. The distance in the Y direction between the center line C1 and the center line C2 in the current sensor 1d was set to 5 mm.

**[Table 2]**

| Table 2 | Current To Be Measured | Detected Magnetic Flux Density |
|---|---|---|
| Current Sensor 1 (Fig. 1A) | 600 A | 61.6 mT |
| Current sensor 1d (Fig. 8) | 900 A | 62.1 mT |

As shown in Fig. 2, by shifting the position of the magnetic detector 3 from the center of the first gap 22 in the Y direction, the magnetic flux density of the magnetic field detected by the magnetic detector 3 can be adjusted. Accordingly, the above-described structure enables an easy replacement of a Hall sensor used as the magnetoresistance effect element in the magnetic detector 3 with a magnetoresistance effect element that has a narrower dynamic range than the Hall sensor.

### [Second embodiment]

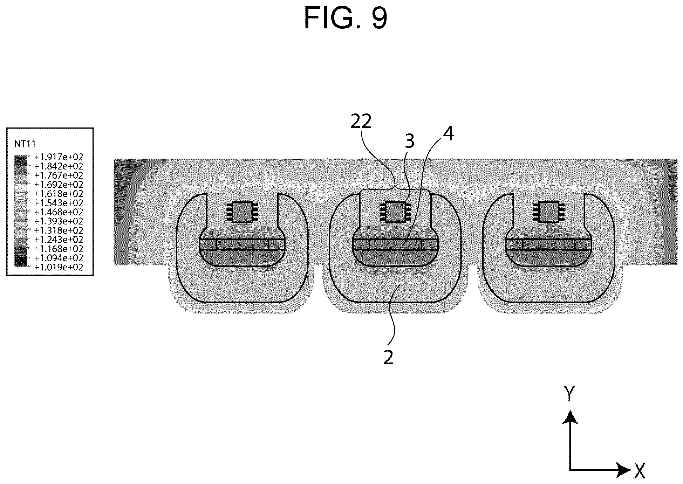

Fig. 9 is a front view of core members 2 when the busbars 4 are energized, in which the temperature of the core members 2 is shown in shades of gray. As illustrated in Fig. 9, when a current to be measured is flowing through the busbars 4, the busbars 4 generate heat. The heat generated at this time is referred to as heat due to Joule heat. As the current to be measured increases, the temperature of the heat due to Joule heat also increases. Under the influence of the heat due to Joule heat from the busbars 4, the temperature in each first gap 22 in the core member 2 becomes approximately the same temperature as the core member 2, and the temperature in the space in the first gap 22 also increases to high temperatures. Accordingly, to suppress the influence of heat due to Joule heat from the busbars 4 via the core members 2, the magnetic detector 3 in the current sensor according to the embodiment is disposed outside the first gap 22.

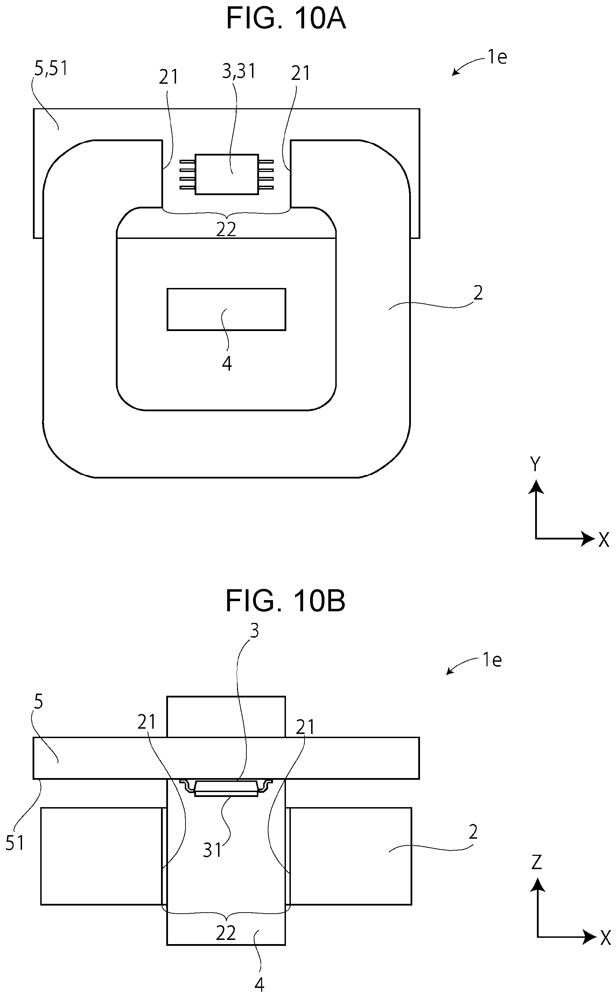

Fig. 10A and Fig. 10B are a front view and a side view of a current sensor 1e according to the embodiment respectively. The magnetic detector 3 in the current sensor 1e is disposed outside the first gap 22. As illustrated in Fig. 10B, the current sensor 1e is different from the current sensor 1 in that the magnetic detector 3 is disposed at a position shifted in the Z direction from the position of the first gap 22 between the end surfaces 21 when viewed in the Y direction. In the current sensor 1e, the magnetic detector 3 is mounted on the substrate 5 by surface mounting, and the plate surface 51 of the substrate 5 is orthogonal to the end surfaces 21, which define the first gap 22. When viewed in a direction orthogonal to the detection surface 31, that is, when viewed in the Z direction, the magnetic detector 3 is disposed to overlap the first gap 22. Such structures of the current sensor 1e are similar to those in the current sensor 1.

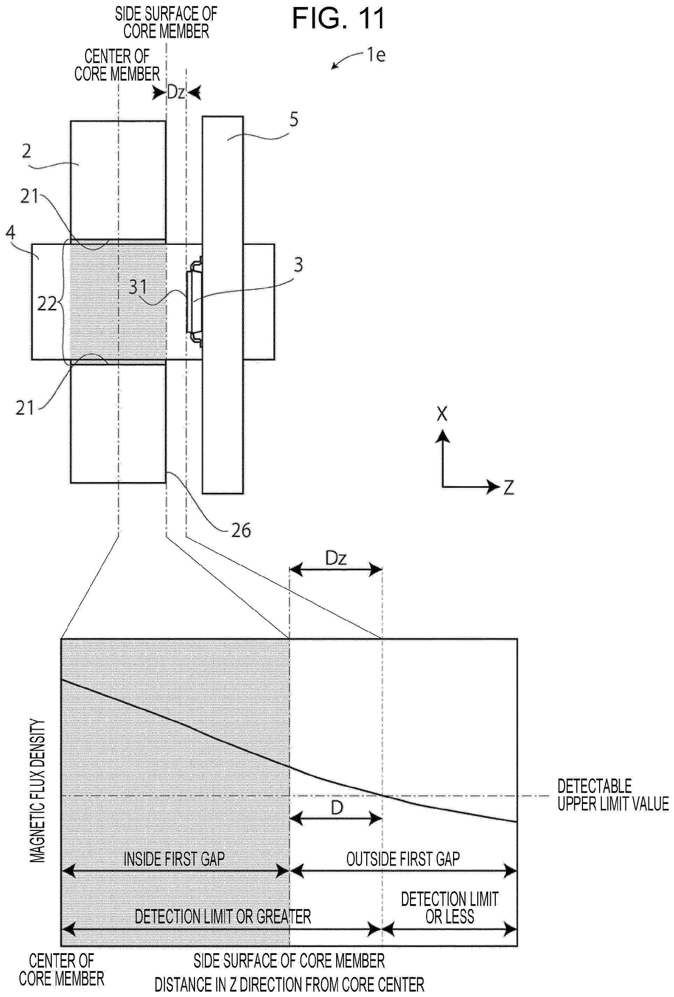

Fig. 11 is a view illustrating a relationship between the position of the magnetic detector 3 in a current sensor 1d and the magnetic flux density. As illustrated in Fig. 11, in the current sensor 1e, the magnetic detector 3 is disposed outside the area of the first gap 22 indicated in gray in Fig. 11. Accordingly, the influence of the heat due to Joule heat generated in the busbar 4 during conduction on the magnetic detector 3 can be suppressed. Accordingly, the current sensor 1e achieves high detection accuracy and durability with reduced detection errors caused by temperature drift in the magnetic detector 3.

When the current to be measured flowing through the busbar 4 is large, the magnetic flux density within the area inside the first gap 22 may reach or exceed a detectable upper limit value of the magnetic detector 3. Depending on the magnitude of the current to be measured flowing through the busbar 4, as shown in the graph in Fig. 11, the magnetic flux density may reach or exceed the detectable upper limit value of the magnetic detector 3 in the area outside the first gap 22 close to a side surface 26 of the core member 2. Accordingly, in the current sensor 1d, the magnetic detector 3 is disposed in the area such that the magnetic flux density is less than or equal to the detectable upper limit value of the magnetic detector 3 when the current to be measured in the busbar 4, which is the detection target, reaches the largest value. In other words, the detection surface 31 of the magnetic detector 3 is disposed at a position away from the side surface 26 of the core member 2 by a distance or further the magnetic flux density becomes less than or equal to the detection upper limit. This arrangement provides the current sensor 1e capable of operating with large currents.

When the distance in the axial direction (Z direction) of the central axis of the circular portion of the core member 2 from the side surface 26 of the core member 2 to the detection surface 31, at which the magnetic flux density reaches the detection limit, is D, it is preferable that a distance Dz from the side surface of the core member 2 to the detection surface 31 be 1.0D to 1.5D, more preferably, 1.0D to 1.3D, and more preferably, 1.0D to 1.2D. This structure provides the current sensor 1e capable of achieving high detection accuracy and operating with large currents.

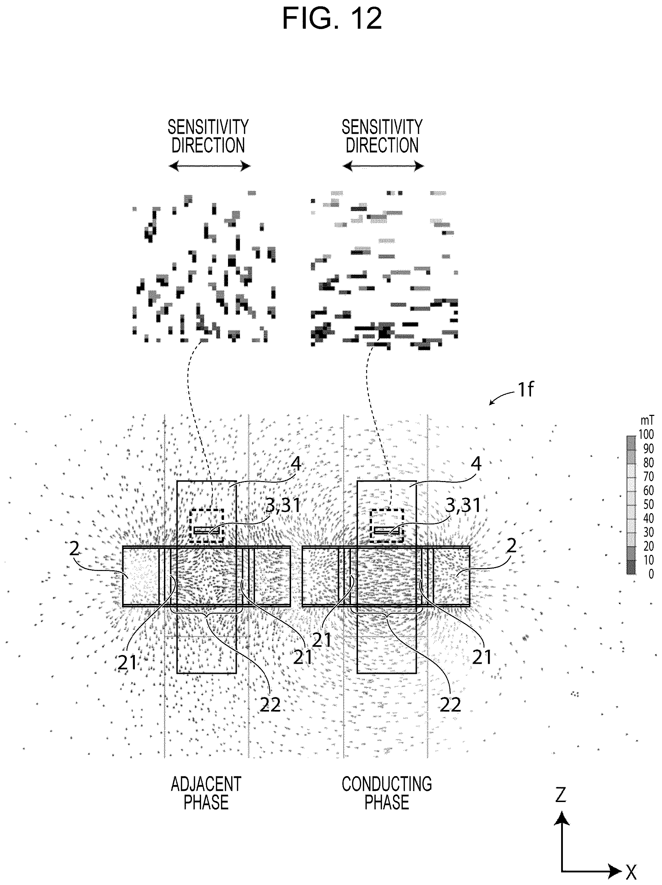

Fig. 12 is a vector diagram illustrating the simulation results of the magnetic fields generated in a conducting phase and an adjacent phase by passing current only through the busbar 4 in the conducting phase without passing current through the busbar 4 in the adjacent phase, and is a diagram of a current sensor 1f with a plurality of measurement phases. When the current sensor 1f has the plurality of measurement phases with the core member 2 and the magnetic detector 3, it is preferable to suppress the effect on the adjacent phase to increase the detection accuracy of the magnetic field.

In the current sensor 1f, the magnetic detector 3 is disposed on an upper side in the Z direction in Fig. 12 and outside the first gap 22. In other words, the detection surface 31 of the magnetic detector 3 is disposed to be shifted with respect to the first gap 22 in the axial direction (Z direction) of the central axis of the circular portion of the core member, when viewed, at the detection surface 31, in the direction (Y direction) orthogonal to the direction (X direction) in which the two end surfaces 21, which define the first gap 22, face each other. In addition, when viewed in the Z direction, the detection surface 31 of the magnetic detector 3 is disposed to overlap the first gap 22 (see Fig. 10A). In the area in which the magnetic detector 3 is disposed in the adjacent phase, the direction of the magnetic field that is generated by the adjacent conducting phase is the Z direction. The sensitivity direction of the magnetic detector 3 in the adjacent phase, which detects the magnetic field in the X direction generated in the vicinity of the first gap 22, is X direction. With this structure, in the magnetic detector 3 disposed in the adjacent phase, the magnetic field from the adjacent conducting phase is orthogonal to the sensitivity direction, and thus the magnetic detector 3 is less affected by the adjacent conducting phase. It should be noted that, when the current is passed through the adjacent phase illustrated in Fig. 12, in the area in the conducting phase in which the magnetic detector 3 is disposed, the direction of the magnetic field that is generated by the neighboring adjacent phase is the Z direction. Accordingly, by the magnetic detector 3 disposed at the position shifted from the first gap 22 in the Z direction, the effect of the magnetic field from the adjacent phase can be suppressed, providing the multi-phase type current sensor 1f with good magnetic field detection accuracy.

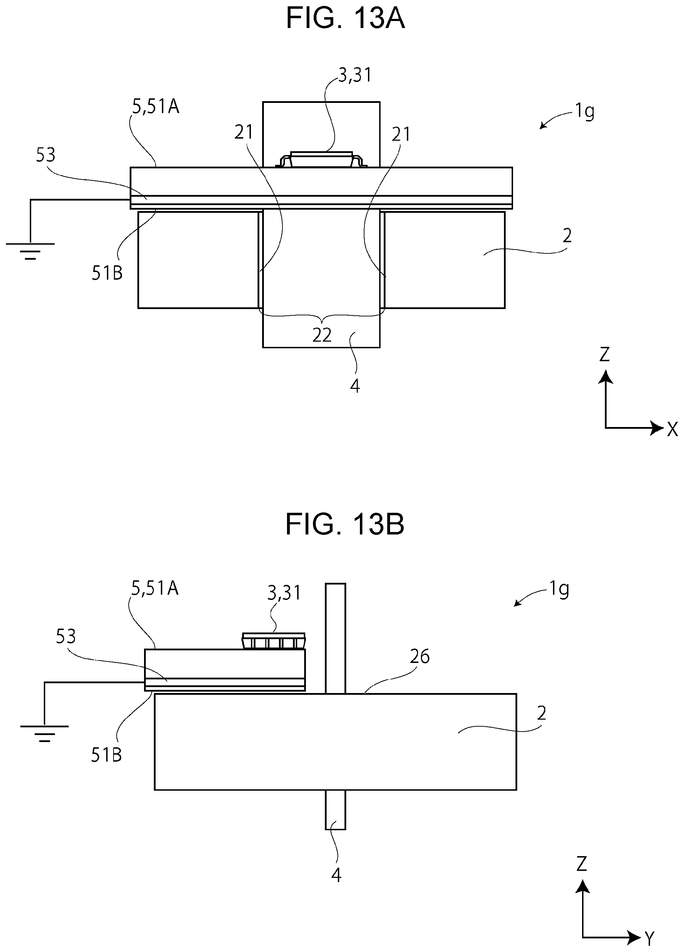

Fig. 13A and Fig. 13B are a front view and a side view of a current sensor 1g according to a modification respectively. The current sensor 1g is different from the current sensor 1e illustrated in Fig. 10A and Fig. 10B in that the substrate 5 that is grounded is disposed between the core member 2 and the magnetic detector 3. More specifically, the magnetic detector 3 is mounted on one side 51A of the substrate 5 by surface mounting, and the other side 51B of the substrate 5 faces the side surface 26 of the core member 2. With this structure, electromagnetic noise picked up by the core member 2 can be shielded by a plane 53 of the GND of the substrate 5, providing the current sensor 1g highly resistant to noise.

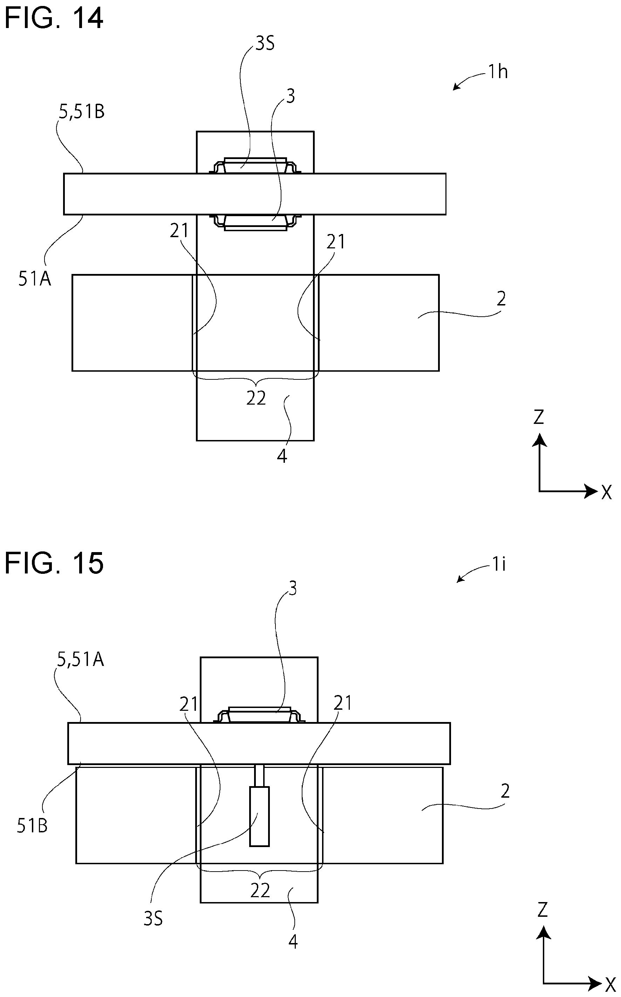

Fig. 14 is a front view of a current sensor 1h according to another modification. In the current sensor 1h, on the substrate 5, a sub-magnetic detector 3S is disposed on the side 51B, which is opposite to the side 51A on which the magnetic detector 3 is disposed. By providing the magnetic detector 3 and the sub-magnetic detector 3S that are mounted on both sides of the substrate 5 respectively to duplicate the detectors, the redundancy can be increased, and even if a functional problem occurs in the magnetic detector 3, the measurement can be made by the sub-magnetic detector 3S.

As a detection element in the sub-magnetic detector 3S in the current sensor 1h, a magnetoresistance effect element may be used. Similarly to the magnetic detector 3, by disposing the sub-magnetic detector 3S outside the first gap 22 of the core member 2, the influence of heat due to Joule heat from the busbar 4 can be reduced.

Fig. 15 is a front view of a current sensor 1i according to another modification. As illustrated in Fig. 15, a Hall sensor can be used as a detection element of the sub-magnetic detector 3S. When the Hall sensor is used as the detection element of the sub-magnetic detector 3S, the detection element of the sub-magnetic detector 3S is disposed in the first gap 22 of the core member 2.

When the Hall sensor is disposed as the sub-magnetic detector 3S on the side 51B opposite to the side 51A of the substrate 5 on which the magnetic detector 3 is disposed, the functional safety by duplication can be achieved and in addition, the different types of detection elements can be provided. The failure modes of the magnetic detector 3 and the sub-magnetic detector 3S are different, and thus it is unlikely that the magnetic detector 3 and the sub-magnetic detector 3S will fail simultaneously, enabling the current sensor 1i to achieve high reliability and safety.

The embodiments disclosed in this specification are in all respects illustrative and not limited to these embodiments. The scope of the invention is defined by the claims, but is not defined by the description of only the above embodiments, and is intended to include all modifications within the meaning and scope equivalent to the claims.

### Industrial Applicability

The present invention is usable as a current sensor that is attached to various devices to measure current to be measured that is flowing through the devices to control or monitor the devices.

### Reference Signs List

1, 1a to 1i CURRENT SENSOR
2, 2a CORE MEMBER
21 END SURFACE
22 FIRST GAP
23 CONVEX PORTION
24 END SURFACE
25 SECOND GAP
26 SIDE SURFACE
3 MAGNETIC DETECTOR
31 DETECTION SURFACE
3S SUB-MAGNETIC DETECTOR
4 BUSBAR
5 SUBSTRATE
51 PLATE SURFACE
51A, 51B SIDE
52 HOLE
53 PLANE
6, 6b, 6c HOUSING
61, 61b, 61c BUSBAR THROUGH HOLE
100 CURRENT SENSOR
103 HALL ELEMENT
105 HOLDING MEMBER
131 DETECTION SURFACE
D, Dz DISTANCE
C1, C2 CENTER LINE
MX FIRST CLEARANCE WIDTH
MY SECOND CLEARANCE WIDTH
O4, O61b, O61c CENTER

## Claims

1. A current sensor comprising:
a core member having a first gap between end surfaces and having a circular shape through which a busbar is insertable, the core member being configured to concentrate a magnetic field generated when a current to be measured passes through the busbar; and
a magnetic detector configured to detect the magnetic field concentrated by the core member, wherein
the magnetic detector has a detection surface that detects the magnetic field and detects the magnetic-field components parallel to the detection surface, and
the detection surface is disposed parallel to the direction in which the two end surfaces defining the first gap face each other.

2. The current sensor according to claim 1, wherein
the magnetic detector is provided on a substrate by surface mounting, and
the plate surface of the substrate is orthogonal to the end surfaces of the core member.

3. The current sensor according to claim 2, wherein the substrate and the core member are secured to each other.

4. The current sensor according to claim 1, wherein the core member has a second gap at a position different from the first gap**.**

5. The current sensor according to claim 1, further comprising:
a housing accommodating the magnetic detector and the core member, wherein
the housing has a busbar through hole into which the busbar is insertable,
the busbar through hole is provided to pass through inside a circular space defined by the core member, and
in a cross-section of the busbar through hole, a first clearance width in the direction in which the two end surfaces defining the first gap face each other is larger than a second clearance width in the direction orthogonal to the direction in which the two end surfaces face each other.

6. The current sensor according to claim 1, further comprising:
the busbar configured to carry the current to be measured, the busbar being disposed to pass through inside a circular space defined by the core member; and
a housing integrally holding the magnetic detector, the core member, and the busbar.

7. The current sensor according to claim 1, wherein
when viewed in an axial direction of a central axis of the circular portion of the core member,
the magnetic detector is disposed at a position shifted with respect to a straight line passing through centers of the two end surfaces defining the first gap, and
at least part of the magnetic detector is disposed to overlap the first gap.

8. The current sensor according to claim 1, wherein a detection element of the magnetic detector is a magnetoresistance effect element.

9. The current sensor according to claim 1, wherein
the magnetic detector is disposed outside the first gap, and
when viewed in a direction orthogonal to the detection surface, is disposed to overlap the first gap.

10. The current sensor according to claim 9, wherein
at the detection surface, when viewed in a direction orthogonal to the direction in which the end surfaces defining the first gap face each other,
the magnetic detector is disposed, with respect to the first gap, in an axial direction of a central axis of the circular portion of the core member, and
when viewed in the axial direction of the central axis of the circular portion of the core member,
the magnetic detector is disposed to overlap the first gap.

11. The current sensor according to claim 9, wherein a grounded substrate is disposed between the core member and the magnetic detector.

12. The current sensor according to claim 11, wherein a sub-magnetic detector is disposed on a side of the substrate opposite to the side on which the magnetic detector is disposed.

13. The current sensor according to claim 12, wherein a detection element of the sub-magnetic detector is a magnetoresistance effect element and is disposed outside the first gap of the core member.

14. The current sensor according to claim 12, wherein a detection element of the magnetic detector is a magnetoresistance effect element,
a detection element of the sub-magnetic detector is a Hall sensor, and
the Hall sensor is disposed in the first gap of the core member.
